# EUROPEAN PATENT SPECIFICATION

(11) **EP 2 305 405 B1**
(45) Date of publication and mention of the grant of the patent: **18.12.2013**
(21) Application number: 09797883.7
(22) Date of filing: 13.07.2009
(51) Int. Cl.: B23B 27/14, B23B 51/00, B23C 5/16, C23C 14/06, C23C 14/32, C23C 14/02

(54) **COATED MEMBER**
BESCHICHTETES ELEMENT
ELÉMENT REVÊTU

(30) Priority: 14.07.2008 JP 2008182123
(43) Date of publication of application: 06.04.2011
(73) Proprietor: Tungaloy Corporation, Iwaki-shi, Fukushima 970-1144 (JP)
(72) Inventor: CHEN, Lu, Iwaki-shi, Fukushima 970-1144 (JP); KOHATA, Mamoru, Iwaki-shi, Fukushima 970-1144 (JP)
(74) Representative: Vossius & Partner
(86) International application number: PCT/JP2009/062651
(87) International publication number: WO 2010/007958

(56) References cited:
- EP-A1- 1 736 565
- JP-A- 8 269 719
- JP-A- 9 059 098
- JP-A- 56 156 767
- JP-A- 2006 021 257
- US-A1- 2004 237 840
- S PALDEY ET AL: "Properties of single layer and gradient (Ti,Al)N coatings", MATERIALS SCIENCE AND ENGINEERING A, vol. 361, no. 1-2, 25 November 2003 (2003-11-25), pages 1-8, XP55011346, ISSN: 0921-5093, DOI: 10.1016/S0921-5093(03)00473-8
- J. M. LACKNER ET AL.: 'Structural, mechanical and tribological investigations of pulsed laser deposited titanium nitride coatings' THIN SOLID FILMS vol. 453-454, 01 April 2004, pages 195 - 202, XP004495224
- M. DOPITA ET AL.: 'Interplay of microstructural features in Crl-xAlxN and Crl-x-yAlxSiyN nanocomposite coatings deposited by cathodic arc evaporation' SURFACE AND COATINGS TECHNOLOGY vol. 202, no. 14-15, 15 April 2008, pages 3199 - 3207, XP022517147

## Description

### TECHNICAL FIELD

The present invention relates to a coated material in which a coating is coated on a surface of a substrate such as a sintered alloy, ceramics, cBN sintered body, diamond sintered body, etc. In particular, it relates to a coated material suitable for a cutting tool represented by a cutting insert, drill and end mill, various kinds of wear resistant tools, and various kinds of wear resistant parts.

### BACKGROUND ART

A coated material in which a coating such as TiC, TiCN, TiN, (Ti,Al)N, CrN, etc., is coated on the surface of a substrate such as a sintered alloy, ceramics, cBN sintered body, diamond sintered body, etc., is frequently used as a cutting tool, wear resistant tool, wear resistant parts since they have both of high strength and high toughness of the substrate, and excellent wear resistance, oxidation resistance, lubricity, welding resistance, etc., of the coating in combination.

As a prior art concerning the coating, there is a hard film for a cutting tool comprising (Ti,Al,Cr)(C,N) (for example, see Patent Literature 1.). Also, as a film excellent in oxidation resistance, there is an Al-Cr-N series film (for example, see Non-Patent Literature 1.). However, due to variation of a material to be cut, cutting conditions, etc., in the cutting tools in which these films are coated, there is a problem that lone life-time cannot be obtained.

A hard film for cutting tools which is composed of Ti_{1-a-b-c-d},Alₐ, Cr_{b}, Si_{c}, B_{d}) (C₁₋ₑNₑ) 0.5 ≤ a ≤ 0.8, 0.06 ≤ b, 0 ≤ c ≤ 0.1, 0 ≤ d ≤ 0.1, 0 ≤ c+d ≤ 0.1, a + b + c + d < 1, 0.5 ≤ e ≤ 1 (where a, b, c, and d denote respectively the atomic ratios Al, Cr, Si, and B, and e denotes the atomic ratio of N) is disclosed in Patent Literature 2.

A surface-coated cemented carbide cutting tool having a specific lubrication-coated layer is disclosed in Patent Literature 3.

[Patent Literature 1] JP 2003-71610A
[Patent Literature 2] US 2004/0237840 A
[Patent Literature 3] JP 2006-021257 A

[Non-Patent Literature1] Yukio Ide, Kazunori Inada, Takashi Nakamura, Katsuhiko Koutake, "Development of Al-Cr-N series film excellent in high temperature anti-oxidative characteristics", "MATERIA" Vol. 40, No. 9, 2001, pp. 815-816

### DISCLOSURE OF THE INVENTION

### PROBLEMS TO BE SOLVED BY THE INTENTION

In recent years, in cutting processing, severe cutting conditions such as high-speed processing, high-feed-rate processing, etc., or severe processing conditions such as higher hardness of a material to be cut, etc., are increasing, so that a further elongation of lifetime tends to be required to coated tools. However, the conventional coated tools could not endure these severe requirements for processing. The present invention has been made in view of such a circumstance, and an object thereof is to provide a coated material which realizes a long life-time in a cutting processing with severe processing conditions such as high-speed processing, high-feed-rate processing, cutting of difficultly cutting materials, etc.

### MEANS TO SOLVE THE PROBLEMS

In the conventional cutting processing, a cutting tool comprising a coated material in which a hard film comprising a cubic metallic compound such as (TiAl)N, (TiCr)N, (CrAl)N, (TiAlCr)N, etc., is coated on the surface of a substrate has been used. The present inventors have earnestly studied to improve properties of a coated material in which (TiAl)N, (TiCr)N, (CrAl)N, (TiAlCr)N, etc., is coated on the surface of a substrate. As a result, they have obtained findings that measurement of the pole figure for the (111) plane and the (220) plane of the hard film is carried out by an X-ray diffraction, and when an X-ray intensity distribution of an α axis in the pole figure for the (111) plane of the hard film shows the maximum intensity of an α angle in the range of 75 to 90° and an X-ray intensity distribution of an α axis in the pole figure for the (220) plane of the hard film shows the maximum intensity of an α angle in the range of 75 to 90°, wear resistance is improved, and when it is used as a cutting tool, it becomes long lifetime. The hard film having such a preferred orientation can be formed by a preliminary discharge step in which impurities which inhibit orientation of the hard film are removed from a substrate by subjecting to arc discharge with a substrate direct current bias voltage of an extremely higher voltage, then, a first discharge step in which generation of cores of crystallization of the hard film is caused by subjecting to arc discharge while gradually decreasing the direct current bias voltage to a predetermined voltage, and finally a second discharge step in which the hard film is formed by subjecting to arc discharge with a predetermined direct current bias voltage. In particular, it is the requirement to form the hard film(s) for a cutting tool that the preliminary discharge is carried out, and then, the hard film(s) is/are formed with a higher voltage than the conventional direct current bias voltage.

That is, the coated material of the present invention comprises a coated material in which a coating is coated on the surface of a substrate, wherein at least one layer of the coating is a hard film comprising a cubic metallic compound, and is a coated material in which an X-ray intensity distribution of an α axis in the pole figure for the (111) plane of the hard film has a maximum intensity in the α angle range of 75 to 90°, and an X-ray intensity distribution of an α axis in the pole figure for the (220) plane of the hard film has a maximum intensity in the α angle range of 75 to 90°.

The present inventors have studied distribution of angles of inclination of a cubic (111) plane and distribution of angles of inclination of a (220) plane constituting the hard film by measurement of the pole figure, and by controlling these values to specific ranges, wear resistance could be improved as compared with that of the conventional hard film.

When measurement of an X-ray diffraction in the pole figure of the hard film of the present invention is carried out, the facts that an X-ray intensity distribution of an α axis in the pole figure for the (111) plane of the hard film shows a maximum intensity in the α angle range of 75 to 90°, and an X-ray intensity distribution of an α axis in the pole figure for the (220) plane of the same shows a maximum intensity in the α angle range of 75 to 90° mean that among cubic crystals which constitute the hard film, the (111) plane and the (220) plane have crystals both directed to parallel to the surface of the coated material with larger amounts. The above could be improved in wear resistance as compared with the coated material showing the maximum intensity in the range of an α angle of less than 75° of the X-ray intensity distribution of an α axis in the pole figure for the (111) plane or the (220) plane of the hard film. The reason is not clear but can be considered that in the hard film of the present invention, the (111) plane and the (220) plane both directed to parallel to the surface of the coated material occupy most of the surface of the hard film, and a dense mixed phase of the (111) plane and the (220) plane can be formed in the hard film, so that wear resistance of the hard film could be improved.

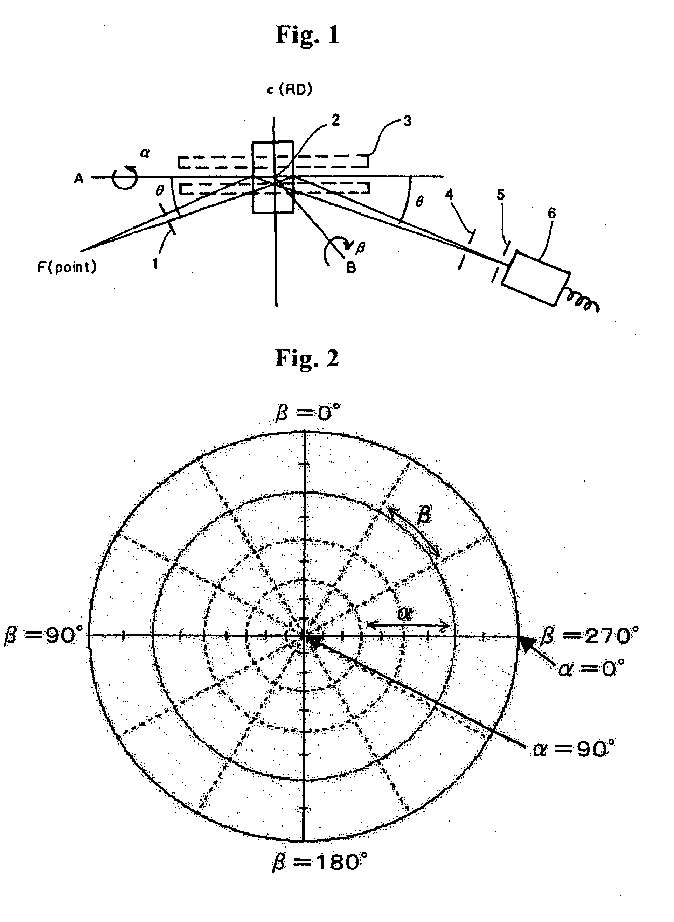

The X-ray intensity distribution of an α axis in the pole figure for the (111) plane and the (220) plane of the hard film of the present invention can be measured by the Schulz reflection method. The Schulz reflection method is, as shown in Fig. 1, a method for measuring an intensity distribution of a diffraction line by changing a direction of a sample to the incident X ray according to an α rotation which is made an A axis in the sample surface a center, and a β rotation which is made a normal (B axis) of the sample surface a center, i.e., a rotation in the sample surface, using an optical system of reflection with equal angles in which 20 is a diffraction angle, and an angle of incident and an angle of reflection are each θ. When B axis is on a plane determined by an incident line and a diffraction line, then, the α angle is defined to be 90°. When the α angle is 90°, it becomes a center point on the pole figure as shown in Fig. 2. As a specific measurement method, for example, by using a pole measurement program of an X ray diffraction analyzer RINT-TTR III available from RIGAKU CORPORATION, an X-ray intensity distribution of an α axis in the pole figure for the (111) plane and the (220) plane of the hard film can be measured by the following mentioned measurement conditions and measurement method.

### [Measurement conditions]

(1) TTR III level goniometer
(2) Multipurpose measurement attachment for pole
(3) Scanning method: concentric circle
(4) β scanning range: 0 to 360°/5° pitch
(5) β scanning speed: 180°/min
(6) γ amplitude: 0 mm

### [Measurement method (Schulz reflection method)]

(1) Fixed angle: a diffraction angle for the (111) plane of the hard film is made 36.7°, and a diffraction angle for the (220) plane of the hard film is made 62°.
(2) α scanning range: 20 to 90° (5° step)
(3) Target: Cu, Voltage: 50 kV, Current: 250 mA
(4) Dissipation slit: 1/4°
(5) Scattering slit: 6 mm
(6) Divergence vertical limit slit: 5 mm

Whereas an α angle showing the maximum intensity can be read from a contour line of the pole figure for the (111) plane and the (220) plane, the α angle showing the maximum intensity can be easily obtained from an X-ray intensity distribution of an α axis in the pole figure for the (111) plane and the (220) plane.

As a substrate of the coated material of the present invention, there may be more specifically mentioned a sintered alloy, ceramics, cBN sintered body, diamond sintered body, etc. Of these, a sintered alloy is preferred since it is excellent in fracture resistance and wear resistance, and of these, a cermet and a hard alloy are more preferred, and a hard alloy is particularly preferred among these.

The coating of the present invention is a coating comprising at least one selected from metal elements of Group 4a, 5a and 6a of the Periodic Table and metals of Al, Y, Mn, Cu, Ni, Co, B, Si, S, Ge and Ga, and an alloy, carbide, nitride or oxide of these metals, and mutual solid solutions thereof, and may be mentioned TiC, TiCN, TiN, (TiAl)N, (CrAl)N, Al₂O₃, etc. At least one layer of the coating is a hard film comprising a cubic metal compound of these metals. An average film thickness of the coating according to the present invention is preferably in the range of 0.1 to 15 µm, more preferably in the range of 0.5 to 10 µm, and particularly preferably in the range of 0.5 to 8 µm. If the average thickness of the coating is 0.1 µm or more, wear resistance and oxidation resistance are improved, and if it is 15 µm or less, fracture resistance is never lowered. Incidentally, an average thickness of the coating according to the present invention means an average value of the thickness by photographing a sectional surface of the coated material in which a coating is coated on the substrate surface with an optical microscope or a scanning electron microscope three portions, and measured on the photographs.

The hard film of the present invention comprises a cubic metal compound of the above-mentioned metals. Of these, if it is a metal compound comprising at least one metal element M selected from Al, Si, Ti, Zr, Hf, V, Nb, Ta, Cr, Mo and W, and at least one element X selected from C, N and O, the metal compound is preferred since hardness is high and wear resistance is excellent. There may be more specifically mentioned TiN, TiC, TiCN, TiCNO, etc. Of these, when the metal element M is at least two selected from Al, Si, Ti, Zr, Hf, V, Nb, Ta, Cr, Mo and W, it is more preferred since the metal compound is excellent in wear resistance. There may be more specifically mentioned (TiAl)N, (TiCr)N, (TiCrAl)N, (CrAl)N, (TiAlSi)N, (TiSi)N, etc. Also, in the hard film of the present invention, the X-ray intensity distribution of the α axis in the pole figure for the (111) plane shows the maximum intensity of the α angle in the range of 75 to 90°, and the X-ray intensity distribution of the α axis in the pole figure for the (220) plane shows the maximum intensity of the α angle in the range of 75 to 90°.

The hard film of the present invention may be either a single layer film comprising 1 layer or a multi-layered film comprising 2 or more layers. Of these, the hard film of the present invention is more preferably an alternately laminated film in which a thin film with a thickness of 1 to 100 nm and having a different composition is alternately laminated two or more layers, since oxidation resistance and wear resistance are improved.

With regard to the composition of the film of the present invention, it can be measured by using an elementary analyzer such as a secondary ion mass spectrometry (SIMS), energy dissipation spectroscopy (EDS), glow discharge spectrometry (GDS), etc.

In the coating of the present invention, when it is a columnar crystal structure grown to the perpendicular direction to the surface of a substrate (columnar crystal structure in which a longitudinal direction is directed to the direction perpendicular to the surface of the substrate), high hardness and excellent wear resistance can be developed, and adhesiveness with the substrate is excellent, so that it is more preferred.

The hard film of the present invention is formed by subjecting to the steps of (1) a step of charging a substrate in a coating device, and heating the same at a substrate temperature of 400 to 650°C by a heater, (2) a preliminary discharge step for removing impurities, (3) a first discharge step for generating cores of crystallization of a hard film, and (4) a second discharge step for growth of the hard film, successively. The preliminary discharge step is, after an Ar gas bombardment of the surface of the substrate, a discharge is carried out by making a pressure in the coating device higher at a predetermined voltage and current of a direct current bias voltage of the substrate: -600 to -1000V, and an arc discharge current: 100 to 150A for 1 to 5 minutes so as to decrease a collision mean free path of the plasma, to remove impurities which inhibit orientation of the hard film from the substrate. At the time of preliminary discharge, substantially no hard film is formed. The first discharge is carried out, after the preliminary discharge, while maintaining the discharge current, substrate temperature, and pressure in the device, arc discharge is carried out by gradually decreasing a direct current bias voltage of the substrate from a predetermined voltage of -600 to -1000V to a predetermined voltage of -80 to -180V over 1 to 5 minutes. At this time, occurrence of cores of crystallization of the hard film is generated. The second discharge is carried out, while maintaining the discharge current, substrate temperature, pressure in the device at the time of the first discharge, by subjecting to discharge at the direct current bias voltage of the substrate: -80 to -180V to form a hard film with a desired film thickness.

Moreover, for the preparation of the hard film of the present invention, for example, an arc ion plating device (hereinafter referred to as AIP device) can be used, and other devices, for example, a sputtering device may be also used. When an AIP device is used, a substrate is charged in a device, a substrate temperature is raised by a heater at 400 to 650°C to carry out an Ar gas bombardment to the substrate. Then, Ar, N₂, O₂ or a mixed gas thereof is introduced into the AIP device, a pressure in the device is made 3 to 6 Pa, and the preliminary discharge, the first discharge, and the second discharge are carried out under the above-mentioned conditions of the direct current bias voltage of the substrate, arc current, etc.

### EFFECTS OF THE INVENTION

The hard film of the present invention is excellent in adhesiveness to the substrate, and excellent in wear resistance. The coated material of the present invention is excellent in wear resistance, fracture resistance and oxidation resistance. When the coated material of the present invention is used as a cutting tool, then, an effect of elongating tool lifetime can be obtained. In particular, it shows higher effect in cutting processing in which processing conditions are severe such as high-speed processing, high-feed-rate processing, processing of a material to be cut with high hardness, cutting of difficultly cutting materials, etc.

### BRIEF DESCRIPTION OF THE DRAWINGS

[Fig. 1] It is a schematic drawing showing optically system of the Schulz reflection method.
[Fig. 2] It is a pole figure showing the positions of an α angle and a β angle.

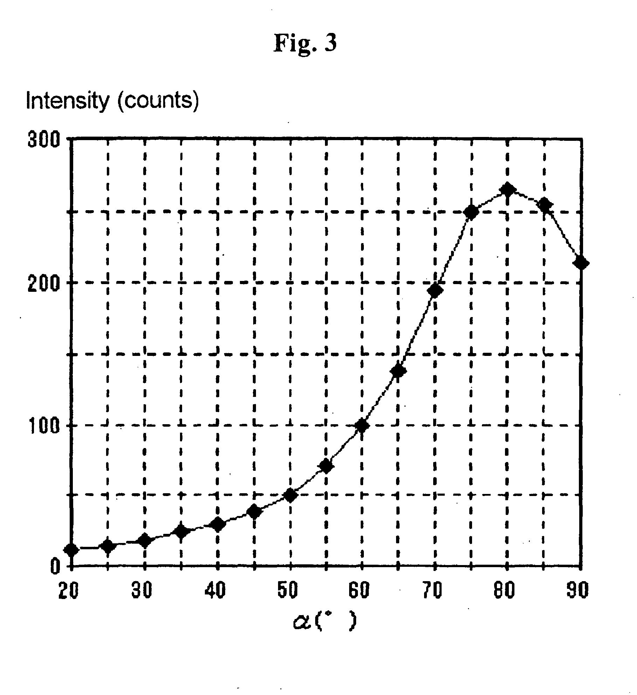

[Fig. 3] It is a drawing showing an X-ray intensity distribution of an α axis in the pole figure for the (111) plane of the hard film of the present product 1.

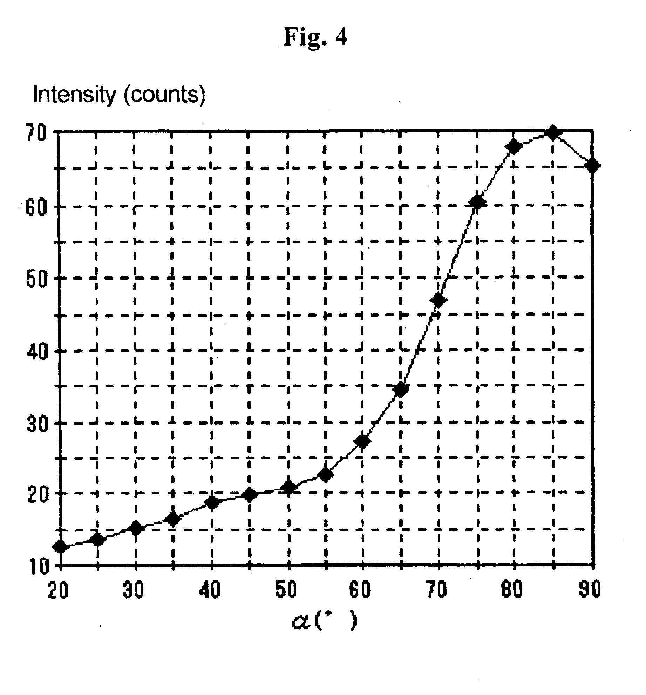

[Fig. 4] It is a drawing showing an X-ray intensity distribution of an α axis in the pole figure for the (220) plane of the hard film of the present product 1.

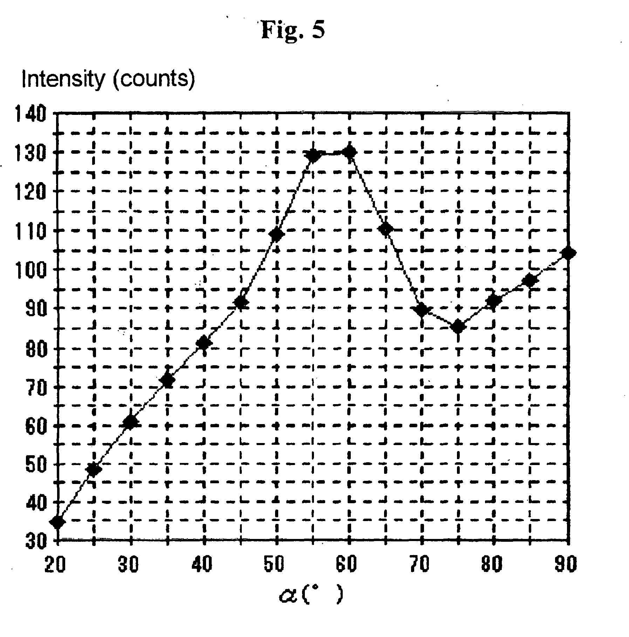

[Fig. 5] It is a drawing showing an X-ray intensity distribution of an α axis in the pole figure for the (111) plane of the hard film of Comparative product 1.

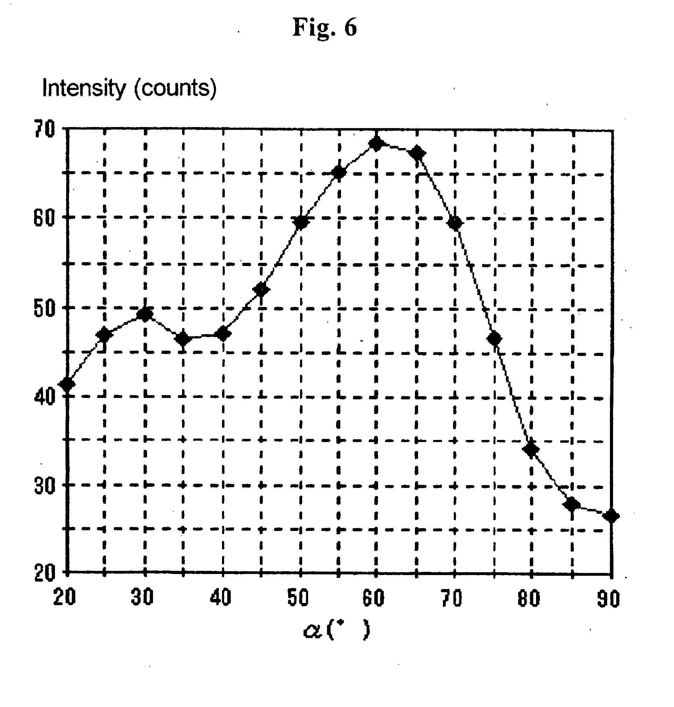

[Fig. 6] It is a drawing showing an X-ray intensity distribution of an α axis in the pole figure for the (220) plane of the hard film of Comparative product 1.

### Example 1

As a substrate, a cutting insert made of a hard alloy corresponding to K20 with a shape of SDKN 1203AETN was prepared. With regard to the present products, as a target for an AIP device, the targets each having a compositional ratio of metal elements and additional elements shown in Tables 1 and 2 were provided in an AIP device. A substrate was charged in the AIP device, a substrate temperature was raised by a heater to 600°C, and after subjecting to an Ar gas bombardment to the substrate, a mixed gas of Ar and N₂ was introduced into the AIP device and a pressure was adjusted to 4 to 5 Pa, and a preliminary discharge was carried out with a direct current bias voltage of the substrate: -600 to -800V and an arc discharge current: 100A for 2 to 3 minutes. After completing the preliminary discharge, the direct current bias voltage of the substrate was gradually adjusted from -600 to -800V to -80 to -120V over 2 minutes, while maintaining the arc discharge current, the substrate temperature and the pressure. Subsequently, under the conditions of a direct current bias voltage of the substrate: -80 to -120V, and an arc discharge current: 100A, discharge was carried out for 100 to 140 minutes in the case of a single layer film to form a hard film with a total film thickness of 3 µm, and in the case of an alternately-laminated film, discharge was carried out for 1 to 1.5 minutes in each layer to form a hard film with a thickness of 10 or 15 nm with 150 or 100 layers.

With regard to Comparative products, the targets each having a compositional ratio of metal elements and additional elements shown in Tables 3 and 4 were provided in an AIP device, and similarly in the present products, a substrate was charged in the AIP device, a substrate temperature was raised by a heater to 600°C. After subjecting to an Ar gas bombardment to the substrate similarly in the present products, a mixed gas of Ar and N₂ was introduced into the AIP device and a pressure was adjusted to 2 Pa, without subjecting to the preliminary discharge, a hard film was coated under the conditions of a direct current bias voltage of the substrate: -40 to -80V, and arc discharge current: 100A. The arc discharge time was the same as that of the present products, but in Comparative products, after the Ar gas bombardment, no preliminary discharge was carried out, and a hard film was coated by making a direct current bias voltage of the substrate usual -40 to -60V.

With regard to the total film thickness of the hard film coated on the surface of the substrate, each sample was cut, the sectional surface was mirror polished, and the resulting mirror-surfaced sectional surface was observed by a 3-views optical microscope and the average value was measured. With regard to the respective film thicknesses of the alternately laminated films, three views of sectional photographs were photographed by using a transmission type electron microscope or FE type scanning electron microscope and an average value of the film thicknesses was made a film thickness of the thin film.

**[Table 1]**

| Sample No. | Hard film | | | |
|---|---|---|---|---|
| | Substrate bias voltage | Film constitution | Film composition | Total film thickness (µm) |
| Present product 1 | -120 | Single layer | (TiCrSi)N | 3 |
| Present product 2 | -100 | Single layer | (TiAlCr)N | 3 |
| Present product 3 | -120 | Single layer | (TiCrZr)N | 3 |
| Present product 4 | -80 | Single layer | (TiAl)N | 3 |

**[Table 2]**

| Sample No. | Hard film | | | | | | |
|---|---|---|---|---|---|---|---|
| | Substrate bias voltage (V) | Layer constitution (First layer is the substrate side) | | Layer constitution | Respective film thickness (nm) | Number of layers | Total film thickness (µm) |
| Present product 5 | -120 | Alternately laminated film | Second layer | (TiCr)N | 15 | 100 | 3 |
| | | | First layer | (CrAl)N | 15 | 100 | |
| Present product 6 | -100 | Alternately laminated film | Second layer | (CrSi)N | 10 | 150 | 3 |
| | | | First layer | (TiAl)N | 10 | 150 | |

**[Table 3]**

| Sample No. | Hard film | | | |
|---|---|---|---|---|
| | Substrate bias voltage | Film constitution | Film composition | Total film thickness (µm) |
| Comparative product 1 | -60 | Single layer | (TiCrSi)N | 3 |
| Comparative product 2 | -40 | Single layer | (TiAlCr)N | 3 |
| Comparative product 3 | -60 | Single layer | (TiCrZr)N | 3 |
| Comparative product 4 | -60 | Single layer | (TiAl)N | 3 |

**[Table 4]**

| Sample No. | Hard film | | | | | | |
|---|---|---|---|---|---|---|---|
| | Substrate bias voltage (V) | Layer constitution (First layer is the substrate side) | | Layer constitution | Respective film thickness (nm) | Number of layers | Total film thickness (µm) |
| Comparative product 5 | -60 | Alternately laminated film | Second layer | (TiCr)N | 15 | 100 | 3 |
| | | | First layer | (CrAl)N | 15 | 100 | |
| Comparative product 6 | -60 | Alternately laminated film | Second layer | (CrSi)N | 10 | 150 | 3 |
| | | | First layer | (TiAl)N | 10 | 150 | |

With regard to the hard films of the respective samples, X-ray diffraction measurement by the 2θ/θ scanning method was carried out by using an X ray diffraction analyzer RINT-TTR III available from RIGAKU CORPORATION, the hard films of all the samples were confirmed to be a cubic Nacl type structure. Also, in the present products 1 to 6, the X ray diffraction peak intensity of the (111) plane was the highest among the X ray diffraction peak intensities of the (111) plane, the (200) plane and the (220) plane of the hard film. In Comparative products 1 to 6, the X ray diffraction peak intensity of the (200) plane was the highest among the X ray diffraction peak intensities of the (111) plane, the (200) plane and the (220) plane of the hard film.

Moreover, by using an X ray diffraction analyzer RINT-TTR III available from RIGAKU CORPORATION, X-ray intensity distribution of the α axis in the pole figure for the (111) plane and the (220) plane of the hard film of the whole samples were measured according to the measurement conditions as mentioned below.

### [Measurement conditions]

(1) TTR III level goniometer
(2) Multipurpose measurement attachment for pole
(3) Scanning method: concentric circle
(4) β scanning range: 0 to 360°/5° pitch
(5) p scanning speed: 180°/min
(6) γ amplitude: 0 mm

### [Measurement method (Schulz reflection method)]

(1) θ fixed angle: a diffraction angle for the (111) plane of the hard film is made 36.7°, and a diffraction angle for the (220) plane of the hard film is made 62°.
(2) α scanning range: 20 to 90° (5° step)
(3) Target: Cu, Voltage: 50kV, Current: 250mA
(4) Dissipation slit: 1/4°
(5) Scattering slit: 6 mm
(6) Divergence vertical limit slit: 5 mm

Also, a hardness of the hard film was measured by using a MICRO-VICKERS hardness tester manufactured by MATSUZAWA SEIKI K.K., with the measurement conditions of an applied load of 25 gf and a retaining time of 15 seconds. These results were shown in Table 5.

**[Table 5]**

| Sample No. | Hard film | | |
|---|---|---|---|
| | α angle (°) showing maximum strength of X-ray intensity distribution of α axis in the pole figure for the (111) plane | α angle (°) showing maximum strength of X-ray intensity distribution of α axis in the pole figure for the (220) plane | Hardness mHV25 |
| Present product 1 | 80 | 85 | 2810 |
| Present product 2 | 85 | 85 | 3130 |
| Present product 3 | 80 | 85 | 3000 |
| Present product 4 | 75 | 90 | 3010 |
| Present product 5 | 75 | 80 | 3280 |
| Present product 6 | 75 | 75 | 3110 |
| Comparative product 1 | 60 | 60 | 2710 |
| Comparative product 2 | 35 | 55 | 2970 |
| Comparative product 3 | 55 | 60 | 2830 |
| Comparative product 4 | 35 | 50 | 2520 |
| Comparative product 5 | 40 | 30 | 3010 |
| Comparative product 6 | 40 | 50 | 2970 |

By using the coated hard alloy tools of the present products 1 to 6, and Comparative products 1 to 6, a dry milling test was carried out under the conditions of a material to be cut: plastic mold steel NAK80 available from Daido Steel Co., Ltd., cutting speed: 150 m/min, cutting depth: 2.0 mm, and feed: 0.15 mm/tooth. Tool lifetime was measured a wear amount of a relief surface VB=0.3 mm as a standard. When the wear amount of a relief surface is not reached to VB=0.3 mm until the cutting length of 6 m, the wear amount of a relief surface VB at the cutting length of 6 m was measured. These results are shown in Table 6.

**[Table 6]**

| Sample No. | Cutting length (m) | VB (mm) | Judgment of Lifetime and Damaged State |
|---|---|---|---|
| Present product 1 | 6.0 | 0.14 | Cutting possible |
| Present product 2 | 6.0 | 0.13 | Cutting possible |
| Present product 3 | 6.0 | 0.13 | Cutting possible |
| Present product 4 | 6.0 | 0.16 | Cutting possible |
| Present product 5 | 6.0 | 0.15 | Cutting possible |
| Present product 6 | 6.0 | 0.17 | Cutting possible |
| Comparative product 1 | 6.0 | 0.32 | Cutting impossible |
| Comparative product 2 | 6.0 | 0.26 | Cutting possible |
| Comparative product 3 | 6.0 | 0.24 | Cutting possible |
| Comparative product 4 | 6.0 | 0.34 | Cutting impossible |
| Comparative product 5 | 6.0 | 0.32 | Cutting impossible |
| Comparative product 6 | 6.0 | - | Broken |

As shown in Table 6, the present products 1 to 6 were not broken by the cutting processing at the cutting length of 6 m, and the wear amount of a relief surface VB is 0.17 mm or less, so that they have excellent wear resistance and fracture resistance. On the other hand, Comparative products showed that the wear amount of a relief surface VB was 0.24 mm or more at the cutting length of 6 m. In addition, Comparative product 6 caused breakage at the cutting length of 6 m.

### [Explanation of reference numerals]

- 1: Dissipation slit (DS)
- 2: Center of the sample
- 3: Divergence vertical limit slit (Schulz slit)
- 4: Light receiving slit (RS)
- 5: Scattering slit (SS)
- 6: Counter

## Claims

1. A coated material which comprises a coated material in which a coating is coated on a surface of a substrate, wherein at least one layer of the coating is a hard film comprising a cubic metallic compound, and is a coated material in which an X-ray intensity distribution of an α axis in a pole figure for a (111) plane of the hard film has a maximum intensity in an α angle range of 75 to 90°, and an X-ray intensity distribution of an α axis in a pole figure for a (220) plane of the hard film has a maximum intensity in an α angle range of 75 to 90°.

2. The coated material according to Claim 1, wherein the hard film is a metallic compound comprising at least one element M selected from the group consisting of Al, Si, Ti, Zr, Hf, V, Nb, Ta, Cr, Mo and W, and at least one element X selected from the group consisting of C, N and O.

3. The coated material according to Claim 2, wherein the element M is two or more kinds selected from Al, Si, Ti, Zr, Hf, V, Nb, Ta, Cr, Mo and W.

4. The coated material according to any one of Claims 1 to 3, wherein an average thickness of the coating is 0.1 to 15 µm.

5. The coated material according to any one of Claims 1 to 4, wherein the hard film comprises alternately laminated films in which two or more thin films having different compositions and each having a thickness of 1 to 100 nm are alternately laminated.

6. A coated cutting tool comprising the coated material according to any one of Claims 1 to 5.

7. A process for preparing a coated material in which a hard film at least one layer of which comprises a cubic metallic compound is coated on a surface of a substrate, which process comprises successively carrying out
(1) a step of charging a substrate in a coating device, and heating the substrate to a temperature of 400 to 650°C,
(2) a preliminary discharge step of, after subjecting an Ar gas bombardment to a surface of the substrate, carrying out discharge at a predetermined voltage and current of a direct current bias voltage of the substrate: -600 to -1000V as well as an arc discharge current: 100 to 150A for 1 to 5 minutes,
(3) a first discharge step of subjecting to an arc discharge by gradually lowering the direct current bias voltage of the substrate at a predetermined voltage of -600 to -1000V to a predetermined voltage of -80 to -180V over 1 to 5 minutes while maintaining the arc discharge current and the temperature of the substrate, and
(4) a second discharge step of subjecting to an arc discharge at the substrate bias voltage: -80 to -180V for a predetermined time while maintaining the arc discharge current and the temperature of the substrate, to obtain the hard film with a desired film thickness.

## Patentansprüche

1. Ein beschichtetes Material, welches ein beschichtetes Material umfasst, bei welchem eine Beschichtung auf eine Oberfläche eines Substrats beschichtet ist, wobei mindestens eine Schicht der Beschichtung ein harter Film ist, der eine kubische metallische Verbindung umfasst, und ein beschichtetes Material ist, in welchem eine Röntgenintensitätsverteilung einer α-Achse in einer Polfigur in einer (111) Ebene des harten Films eine maximale Intensität in einem α-Winkelbereich von 75 bis 90° aufweist, und eine Röntgenintensitätsverteilung einer α-Achse in einer Polfigur in einer (220) Ebene des harten Films eine maximale Intensität in einem α-Winkelbereich von 75 bis 90° aufweist.

2. Das beschichtete Material gemäß Anspruch 1, wobei der harte Film eine metallische Verbindung ist, die mindestens ein Element M, ausgewählt aus der Gruppe bestehend aus Al, Si, Ti, Zr, Hf, V, Nb, Ta, Cr, Mo und W und mindestens ein Element X, ausgewählt aus der Gruppe bestehend aus C, N und O, umfasst.

3. Das beschichtete Material gemäß Anspruch 2, wobei das Element M zwei oder mehr Arten, ausgewählt aus Al, Si, Ti, Zr, Hf, V, Nb, Ta, Cr, Mo und W, ist.

4. Das beschichtete Material gemäß einem der Ansprüche 1 bis 3, wobei eine mittlere Dicke der Beschichtung 0,1 bis 15 µm beträgt.

5. Das beschichtete Material gemäß einem der Ansprüche 1 bis 4, wobei der harte Film abwechselnd laminierte Filme umfasst, in welchen zwei oder mehr dünne Filme, die verschiedene Zusammensetzungen aufweisen und jeweils eine Dicke von 1 bis 100 nm aufweisen, abwechselnd laminiert sind.

6. Ein beschichtetes Schneidewerkzeug, welches das beschichtete Material gemäß einem der Ansprüche 1 bis 5 umfasst.

7. Ein Verfahren zur Herstellung eines beschichteten Materials, in welchem ein harter Film, bei dem mindestens eine Schicht eine kubische metallische Verbindung umfasst, auf eine Oberfläche eines Substrats beschichtet ist, wobei das Verfahren das aufeinanderfolgende Durchführen umfasst
von
(1) einem Schritt des Einbringens eines Substrats in eine Beschichtungsvorrichtung und Erwärmens des Substrats auf eine Temperatur von 400 bis 650°C,
(2) einem vorausgehenden Entladungsschritt, nachdem eine Oberfläche des Substrats einem Argongas-Bombardement ausgesetzt wurde, des Durchführens einer Entladung bei einer vorbestimmten Spannung und einem vorbestimmten Strom der Gleichstrom-Vorspannung des Substrats: -600 bis -1000 V sowie einem Bogenentladungsstrom: 100 bis 150 A für 1 bis 5 Minuten,
(3) einem ersten Entladungsschritt des Unterziehens einer Bogenentladung durch allmähliche Verringerung der Gleichstrom-Vorspannung des Substrats bei einer vorbestimmten Spannung von -600 bis -1000 V zu einer vorbestimmten Spannung von -80 bis -180 V über 1 bis 5 Minuten, während der Bogenentladungsstrom und die Temperatur des Substrats beibehalten werden, und
(4) einem zweiten Entladungsschritt des Unterziehens einer Bogenentladung bei der Substrat-Vorspannung: -80 bis -180 V für eine vorbestimmte Zeit, während der Bogenentladungsstrom und die Temperatur des Substrats beibehalten werden, um den harten Film mit einer gewünschten Filmdicke zu erhalten.

## Revendications

1. Matériau revêtu qui comprend un matériau revêtu dans lequel un revêtement est revêtu sur une surface d'un substrat, dans lequel au moins une couche du revêtement est un film dur comprenant un composé métallique cubique, et est un matériau revêtu dans lequel une distribution d'intensité des rayons X d'un axe α dans une figure de pôle pour un plan (111) du film dur a une intensité maximale dans une plage d'angle α de 75 à 90°, et une distribution d'intensité des rayons X d'un axe α dans une figure de pôle pour un plan (220) du film dur a une intensité maximale dans une plage d'angle α de 75 à 90°.

2. Matériau revêtu selon la revendication 1, dans lequel le film dur est un composé métallique comprenant au moins un élément M choisi dans le groupe constitué par Al, Si, Ti, Zr, Hf, V, Nb, Ta, Cr, Mo et W, et au moins un élément X choisi dans le groupe constitué par C, N et O.

3. Matériau revêtu selon la revendication 2, dans lequel l'élément M est de deux types ou plus choisis parmi Al, Si, Ti, Zr, Hf, V, Nb, Ta, Cr, Mo et W.

4. Matériau revêtu selon l'une quelconque des revendications 1 à 3, dans lequel une épaisseur moyenne du revêtement est de 0,1 à 15 µm.

5. Matériau revêtu selon l'une quelconque des revendications 1 à 4, dans lequel le film dur comprend alternativement des films stratifiés dans lequel deux films fins ou plus ayant des compositions différentes et ayant chacun une épaisseur de 1 à 100 nm sont alternativement stratifiés.

6. Outil de coupe revêtu comprenant le matériau revêtu selon l'une quelconque des revendications 1 à 5.

7. Procédé de préparation d'un matériau revêtu dans lequel un film dur dont au moins une couche comprend un composé métallique cubique est revêtu sur une surface d'un substrat, ledit procédé comprenant successivement la mise en oeuvre de
(1) une étape consistant à charger un substrat dans un dispositif de revêtement, et à chauffer le substrat à une température de 400 à 650 °C,
(2) une étape de décharge préliminaire consistant à, après avoir soumis une surface du substrat à un bombardement d'Ar gazeux, réaliser une décharge à une tension prédéterminée et un courant d'une tension de polarisation en courant continu du substrat de -600 à -1000 V ainsi qu'un un courant de décharge en arc de 100 à 150 A pendant 1 à 5 minutes,
(3) une première étape de décharge consistant à soumettre à une décharge en arc par réduction progressive de la tension de polarisation en courant continu du substrat à une tension prédéterminée de -600 à -1000 V, à une tension prédéterminée de -80 à -180 V pendant 1 à 5 minutes tout en maintenant le courant de décharge en arc et la température du substrat, et
(4) une seconde étape de décharge consistant à soumettre à une décharge en arc à la tension de polarisation du substrat de -80 à -180 V pendant une durée prédéterminée tout en maintenant le courant de décharge en arc et la température du substrat, pour obtenir le film dur ayant une épaisseur de film souhaitée.
